# EUROPEAN PATENT SPECIFICATION

(11) **EP 2 979 582 B1**
(45) Date of publication and mention of the grant of the patent: **14.06.2017**
(21) Application number: 14179234.1
(22) Date of filing: 31.07.2014
(51) Int. Cl.: A47B 88/57

(54) **Slide rail assembly**
Schienenanordnung
Ensemble de rail de glissement

(43) Date of publication of application: 03.02.2016
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Fang, Chiang-Hsueh, Kaohsiung City (TW); Wang, Chun-Chiang, Kaohsiung City (TW)
(74) Representative: Viering, Jentschura & Partner mbB Patent- und Rechtsanwälte

(56) References cited:
- DE-U1-202009 011 027
- US-A1- 2002 074 914
- US-A1- 2008 246 378

## Description

### Field of the Invention

The invention relates to a slide rail assembly, and more particularly, to a slide rail assembly ensuring that one rail of the slide rail assembly does not dislocate from the other rail when being pulled and moved with respect to the other rail to a predetermined position.

### Background of the Invention

Generally speaking, slide rail assemblies are respectively configured on the two corresponding sides of a server chassis for rack server systems. By means of a bracket assembly connected with the slide rail assembly, the slide rail assembly is correspondingly mounted on the rack so that the chassis may be mounted on the rack.

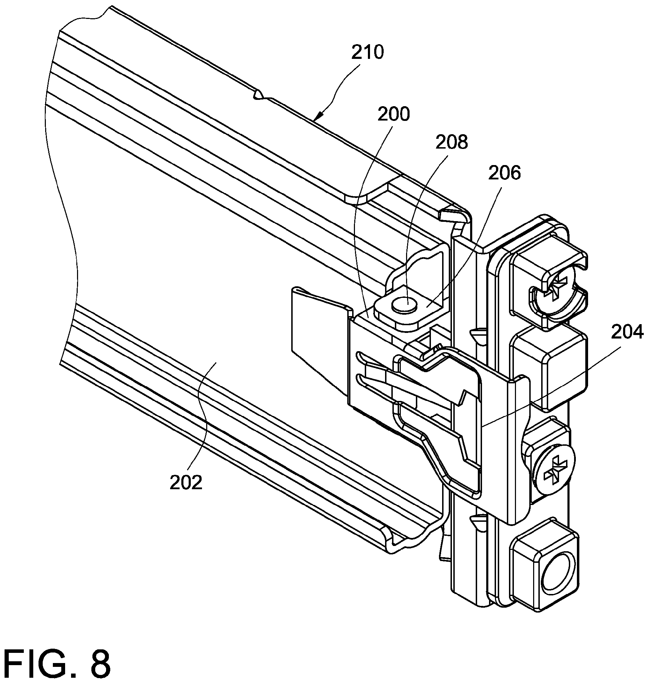

U.S. Patent No. 8,371,454 B2 disclosed a bracket assembly for a rack. It may be understood from the description and drawings (e.g. FIG. 8) that when a user assembles the bracket components to the post 86 of the rack 84, the user may penetrate the mounting member 32 of the end plate 14 of the bracket 10 through the post hole 88 of the rack 84, and by pressing the elastic leg 42 of the arm member 40 against the base 30, the fastening arm 44 of the arm member 40 retains an elastic force relative to the elastic leg 42 so that the fastening portion 46 of the fastening arm 44 retains elastic force and blocks in front of the rack 84 to ensure that the bracket components do not dislocate from the rack 84

A slide rail assembly according to the preamble of claim 1 or 11 is known from US 2002/074914 A1.

Furthermore, although conventional slide rail assemblies may also have engaging mechanisms configured between the two corresponding rails so as to provide a protection mechanism, by which a rail may be blocked at a predetermined position and not be dislocated from the other rail when the rail is moved longitudinally with respect to the other rail, the structural design of the engaging mechanism is usually over-complicated and the operations to disable the protection mechanism are inconvenient for the user.

Therefore, the providing of a product that has a simple structure and is convenient for users to operate has been a crucial topic of development and design.

### Summary of the Invention

The present invention is a slide rail assembly that ensures that one rail of the slide rail assembly does not dislocate from the other rail when being pulled and moved with respect to the other rail to a predetermined position. The invention provides a slide rail assembly according to claim 1.

Preferably, the arm member of the bracket assembly further comprises a first arm section and a second arm section bending from the first arm section, wherein the first arm section comprises the blocking portion and the second arm section extends beyond the rack by a distance and faces the rack.

Preferably, the side plate of the bracket assembly comprises a base, wherein the bracket assembly further comprises a connection member, and wherein the connection member pivotally connects the arm member to the base of the side plate.

Preferably, the location of the blocking portion of the bracket assembly extends beyond the end plate by a distance.

Preferably, the first rail comprises an end, wherein the side plate of the bracket assembly is connected to the end of the first rail.

Preferably, the engaging member further comprises a base plate connected to the second rail and an inclining portion bending from the base plate, wherein the contact portion is located on the inclining portion, and wherein when the second rail is blocked at the predetermined position, the inclining portion is able to be pressed to separate the contact portion of the engaging member from the blocking portion of the arm member. The contact portion comprises a slant corresponding to the arm member, wherein when the second rail is moved along an opposite direction with respect to the first rail and drives the slant to contact the arm member, the inclining portion of the engaging member is pressed so that the contact portion of the engaging member can pass the arm member. The second rail comprises a rail hole and a hole edge adjacent to the rail hole, wherein the engaging member further comprises a supporting portion connected to the inclining portion and bent towards the second rail, and wherein the supporting portion comprises a blocking wing penetrating the rail hole and blocked by the hole edge.

Preferably, the arm member further comprises an arm hole, wherein the blocking portion is an edge adjacent to the arm hole, wherein the contact portion of the engaging member is a protrusion, and wherein when the second rail is pulled and moved along the direction with respect to the first rail to the predetermined position, the protrusion of the engaging member is located at the arm hole of the arm member and is blocked by the edge of the arm member to block the second rail at the predetermined position. The invention also provides a slide rail assembly according to claim 11.

Preferably, the first rail comprises a base, wherein a connection member pivotally connects the arm member to the base of the first rail.

A feature of the embodiments of invention is that the blocking portion of the arm member blocks the contact portion of the engaging member so that the second rail is blocked at a predetermined position and does not dislocate from the first rail when the second rail of the slide rail assembly is pulled and moved along the direction with respect to the first rail to the predetermined position.

### Brief Description of the Drawings

FIG. 1 shows a perspective view of a slide rail assembly mounted to a rack by means of at least one bracket assembly according to an embodiment of the present invention;
FIG. 2 is an exploded view of the slide rail assembly mounted to the rack by means of the bracket assembly according to an embodiment of the present invention;
FIG. 3 is an exploded view of a second rail and a first rail of the slide rail assembly of FIG. 1;
FIG. 4 is an exploded schematic of the second rail and an engaging member of FIG. 3;
FIG. 5A shows a schematic of the slide rail assembly mounted to the rack by means of at least one bracket assembly before the second rail moves to a predetermined position according to an embodiment of the present invention;
FIG. 5B shows a schematic of FIG. 5A after the second rail is pulled and moved to the predetermined position;
FIG. 6A shows a schematic of an inclining portion of the engaging member pressed so that a contact portion of the engaging member is not blocked by a blocking portion of an arm member after the second rail of the slide rail assembly is blocked at the predetermined position with respect to the first rail according to an embodiment of the present invention;
FIG. 6B shows a schematic of further continuing to pull and move the second rail along a direction after the contact portion of the engaging member is not blocked by the blocking portion of the arm member according to an embodiment of the present invention;
FIG. 7 shows a schematic of the second rail moving in a withdrawing direction according to an embodiment of the present invention; and
FIG. 8 shows a schematic of a slide rail assembly comprising an arm member according to another embodiment of the present invention.

### Detailed Description of the Invention

The structures, features, advantages, and purposes of the present invention may be more fully understood by the subsequent detailed description and examples with references made to the accompanying drawings.

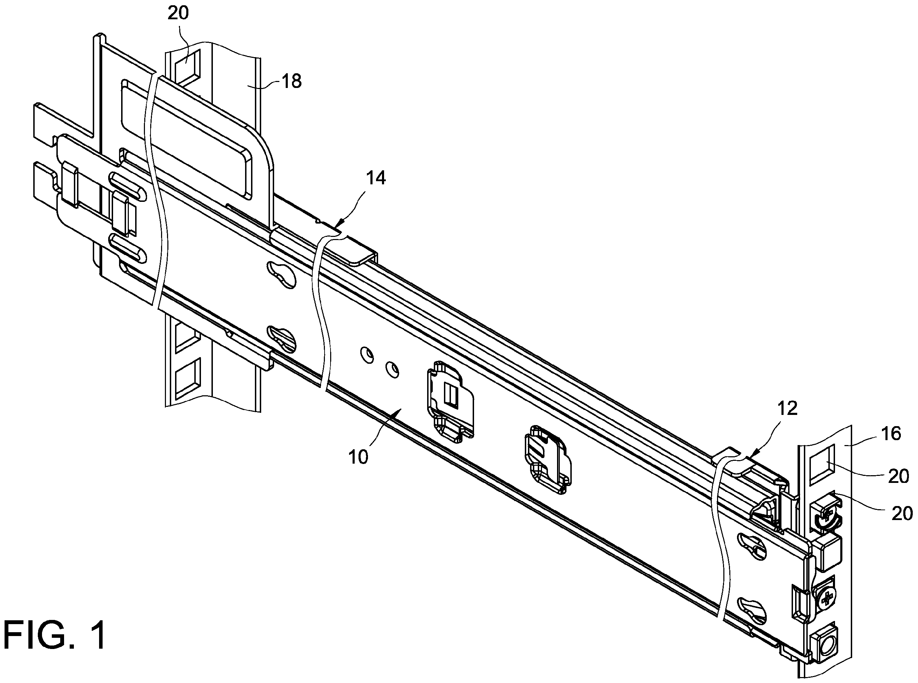

FIG. 1 shows a slide rail assembly 10 mounted to a rack by means of at least one bracket assembly according to an embodiment of the present invention. The two opposite ends of the slide rail assembly 10 are mounted to a first post 16 and a second post 18 of the rack by means of a first bracket assembly 12 and a second bracket assembly 14, respectively. The first post 16 and the second post 18 each comprises a plurality of post holes 20, wherein the plurality of post holes 20 may be square holes, circular holes, or holes of other shapes. Square holes are used here for an example, but the present invention is not limited thereto. Since the assembled configuration of the second bracket assembly 14 and the second post 18 is generally the same as that of the first bracket assembly 12 and the first post 16, the following descriptions shall only be made for the assembled configuration of the first bracket assembly 12 and the first post 16.

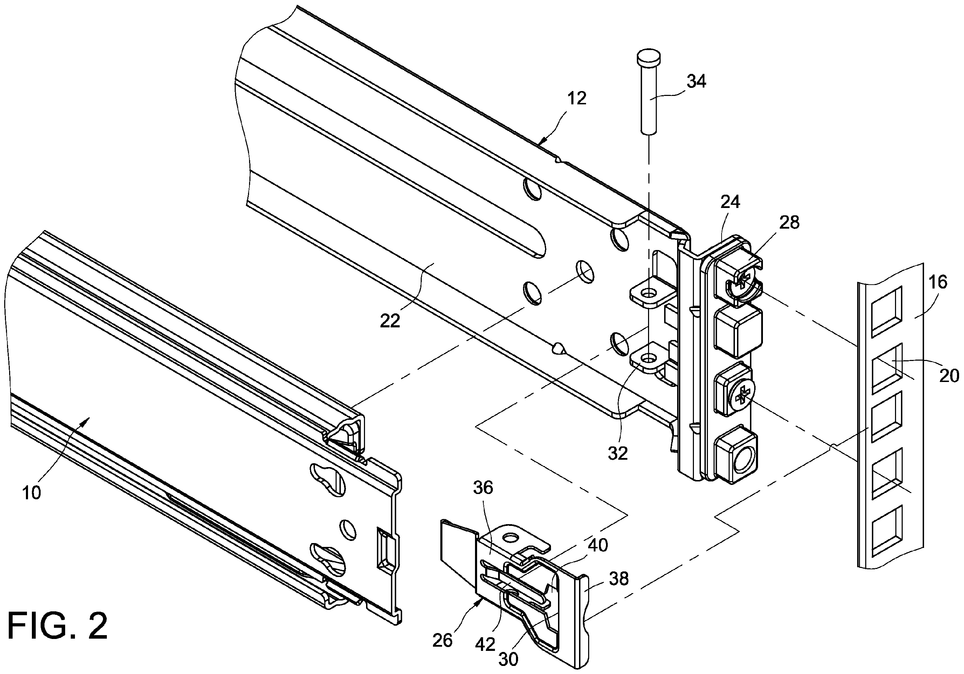

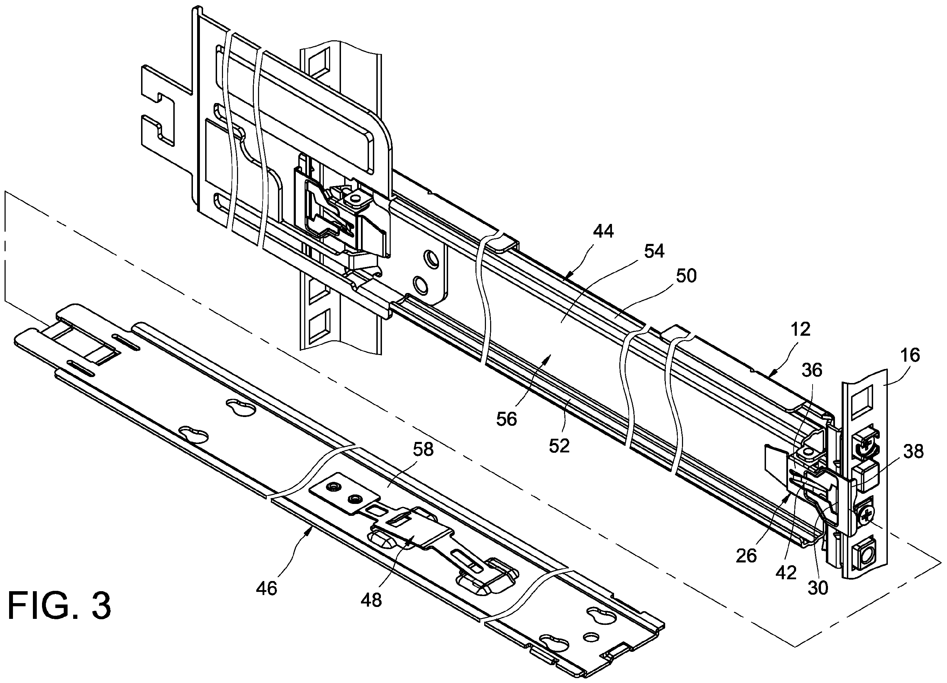

As shown in FIG. 2 and FIG. 3, the first bracket assembly 12 comprises a side plate 22, an end plate 24, an arm member 26, and a mounting member 28. The end plate 24 bends from the side plate 22 and more particularly, the end plate 24 is substantially perpendicularly connected to the side plate 22. The mounting member 28 is connected to the end plate 24 and may be correspondingly mounted to the post hole 20 of the first post 16. The arm member 26 is connected (e.g., movably connected) to the side plate 22 and comprises a blocking portion 30.

In a preferred embodiment, the side plate 22 of the first bracket assembly 12 comprises a base 32 laterally connected to the side plate 22, wherein the first bracket assembly 12 further comprises a connection member 34 pivotally connecting the arm member 26 to the base 32 of the side plate 22 so that the arm member 26 may be operated to rotate with respect to the side plate 22.

Specifically, the arm member 26 further comprises a first arm section 36 and a second arm section 38. The second arm section 38 bends from the first arm section 36 and more particularly, the second arm section 38 is substantially perpendicular to the first arm section 36. The first arm section 36 comprises the blocking portion 30. Preferably, the first arm section 36 further comprises an arm hole 40, wherein the blocking portion 30 is an edge adjacent to the arm hole 40, and wherein the location of the blocking portion 30 extends beyond the end plate 24 by a distance when the arm member 26 is pivotally connected to the base 32 of the side plate 22. In addition, the arm member 26 further comprises an elastic portion 42 (such as an elastic leg) correspondingly pressing against a portion of the first bracket assembly 12 so that the elastic portion 42 provides an elastic force to the arm member 26. Preferably, the elastic portion 42 extends from the first arm section 36 of the arm member 26 so that the second arm section 38 of the arm member 26 remains correspondingly facing the end plate 24 by means of the elastic force and is located in front of the first post 16 by a distance when the first bracket assembly 12 is mounted to the first post 16 (as shown in FIG. 3).

The slide rail assembly 10 comprises a first rail 44, a second rail 46, and an engaging member 48.

The first rail 44 is connected to the side plate 22 of the first bracket assembly 12. More particularly, the side plate 22 of the first bracket assembly 12 is connected to an end of the first rail 44 (such as a front end). The first rail 44 comprises an upper wall 50, a lower wall 52, and a side wall 54 extending between the upper wall 50 and the lower wall 52, wherein the upper wall 50, the lower wall 52, and the side wall 54 collectively define a longitudinal channel 56.

The second rail 46 corresponds to and is longitudinally and movably connected to the first rail 44, wherein the second rail 46 comprises a longitudinally extending body 58 corresponding to and longitudinally movable along the longitudinal channel 56 of the first rail 44.

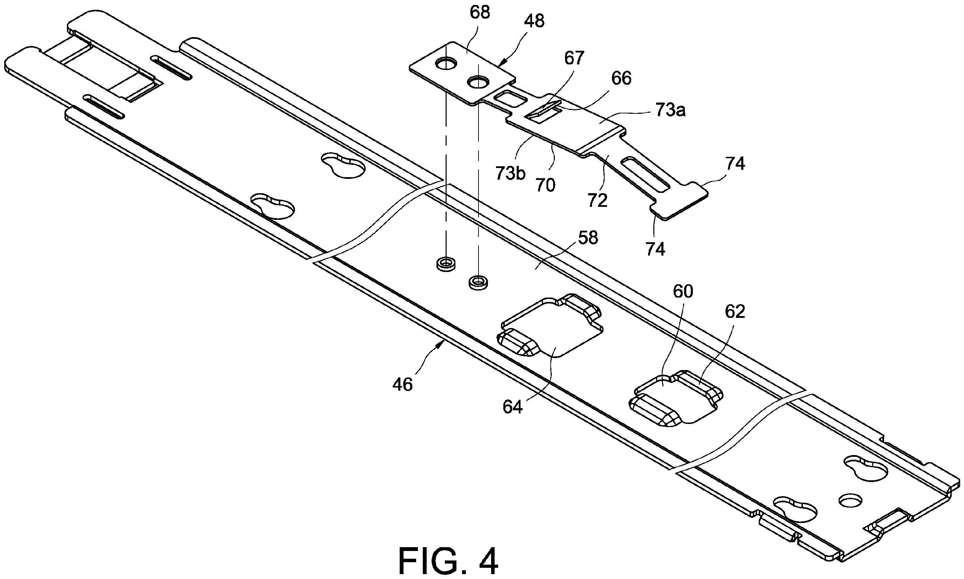

As shown in FIG. 3 and FIG. 4, the longitudinally extending body 58 of the second rail 46 comprises a rail hole 60, a hole edge 62 adjacent to the rail hole 60, and another rail hole 64; the engaging member 48 is connected to the longitudinally extending body 58 of the second rail 46 and comprises a first side 73a and a second side 73b that are opposite to each other, wherein the second side 73b faces the longitudinally extending body 58 of the second rail 46. The engaging member 48 comprises a contact portion 66 on the first side 73a, wherein the contact portion 66 corresponds in configuration to the blocking portion 30 of the arm member 26 and more particularly, the contact portion 66 is a protrusion, but the present invention is not limited thereto. The contact portion 66 comprises a slant 67 and preferably, the engaging member 48 further comprises a base plate 68, an inclining portion 70, and a supporting portion 72.

The base plate 68 is connected to the longitudinally extending body 58 of the second rail 46; the inclining portion 70 bends from the base plate 68 and is elastic, wherein the contact portion 66 is located on the inclining portion 70; the supporting portion 72 is connected to the inclining portion 70 and bent towards the longitudinally extending body 58 of the second rail 46, wherein the supporting portion 72 comprises at least one blocking wing 74 penetrating the rail hole 60 of the second rail 46 and being blocked by the hole edge 62 to elastically confine the inclining portion 70 at a working position.

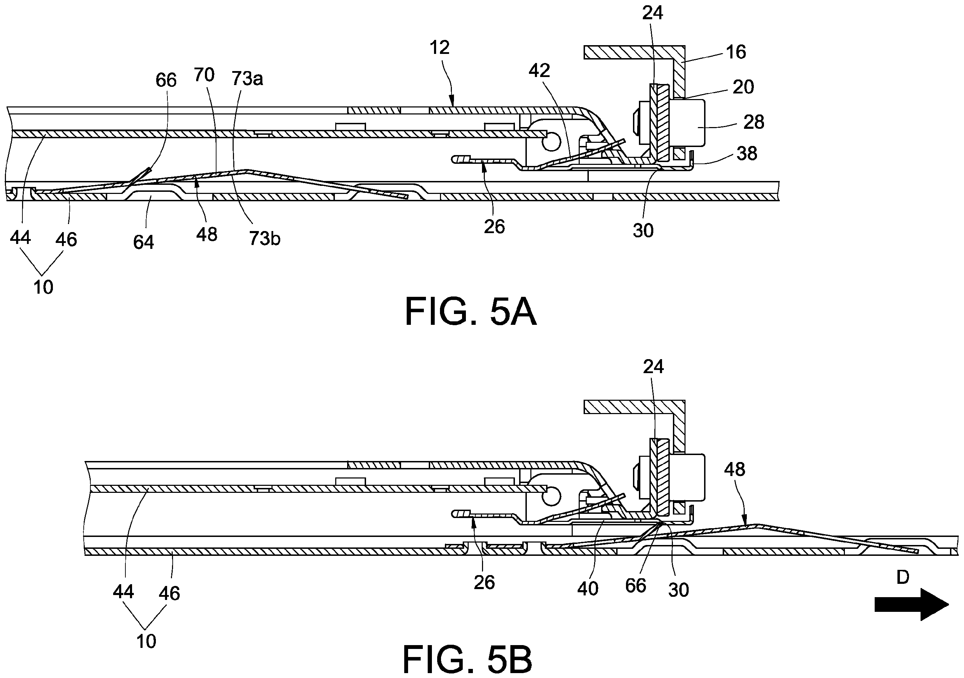

Moreover, the inclining portion 70 of the engaging member 48 corresponds in position to the another rail hole 64 of the longitudinally extending body 58 of the second rail 46 to be used by a user at discretion. For example, the user may push the second side 73b of the engaging member 48 through the another rail hole 64 from one side of the second rail 46 (as shown in FIG. 5A) to adjust the extent of the inclining portion 70 bending from the base plate 68 so that the inclining portion 70 remains at the working position, but the function of the another rail hole 64 is not limited thereto.

As shown in FIG. 5A and FIG. 5B, after the slide rail assembly 10 is mounted to the post hole 20 of the first post 16 by means of the mounting member 28 of the bracket assembly (such as the first bracket assembly 12 and the second bracket assembly 14; FIG. 5A and FIG. 5B only show the first bracket assembly 12), the user may further operate the arm member 26 so that the second arm section 38 of the arm member 26 remains correspondingly blocking in front of the first post 16 by means of the elastic force provided by the elastic portion 42 (i.e., the second arm section 38 of the arm member 26 extends beyond the first post 16 by a distance and faces the first post 16), so as to prevent the slide rail assembly 10 from accidentally dislocating from the first post 16 by means of the blocking by the second arm section 38 of the arm member 26.

When the second rail 46 of the slide rail assembly 10 is pulled from a position (as in FIG. 5A) and moved along a direction D with respect to the first rail 44 to a predetermined position (as in FIG. 5B), the contact portion 66 (such as a protrusion) of the engaging member 48 is correspondingly located at the arm hole 40 of the arm member 26 and thereby blocked by the blocking portion 30 (such as an edge) of the arm member 26 so that the second rail 46 is blocked at the predetermined position with respect to the first rail 44. Accordingly, the second rail 46 is ensured not to be dislocated from the first rail 44. Therefore, when the second rail 46 is mounted with a chassis (such as a server chassis), the chassis is ensured not to be damaged due to the second rail 46 dislocating from the first rail 44.

In the embodiment, since the blocking portion 30 of the arm member 26 extends beyond the end plate 24 by a distance, the contact portion 66 of the engaging member 48 is not blocked by the edge of the end plate 24 when entering the arm hole 40 of the arm member 26, and the blocking portion 30 of the arm member 26 may indeed block the contact portion 66 of the engaging member 48. In addition, although the contact portion 66 of the engaging member 48 is a protrusion and the blocking portion 30 of the arm member 26 is an edge to block the protrusion of the engaging member 48, in another embodiment, the contact portion 66 of the engaging member 48 may be an edge and the blocking portion 30 of the arm member 26 may be a protrusion to block the edge of the engaging member 48 and the present invention is not limited thereto.

It should be noted that, the second rail 46 may be directly pushed from the predetermined position (as in FIG. 5B) in a withdrawing direction (i.e., opposite to the direction D) so that the second rail 46 may be withdrawn from the predetermined position in the withdrawing direction with respect to the first rail 44 (as in FIG. 5A).

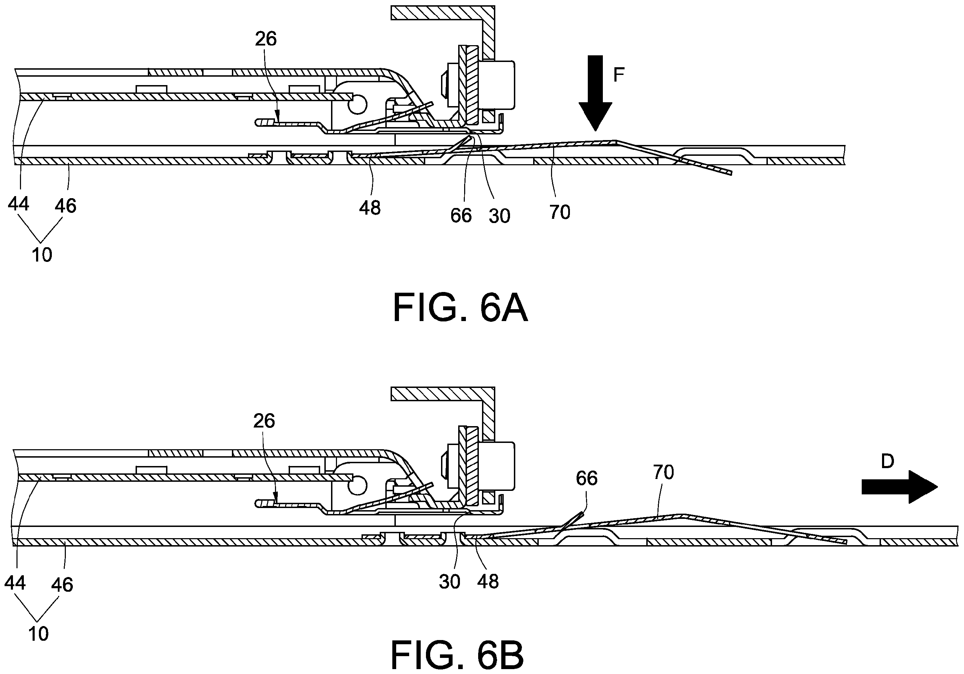

As shown in FIG. 6A and FIG. 6B, after the second rail 46 is blocked at the predetermined position, the user may directly apply a force F to press the inclining portion 70 of the engaging member 48 so that the contact portion 66 of the engaging member 48 may be dislocated from and no longer blocked by the blocking portion 30 of the arm member 26 (as in FIG. 6A), and the design of which may be more convenient for the user to operate; under such a condition, the user may further continue to pull and move the second rail 46 along the direction D (as in FIG. 6B) so that the second rail 46 is dislocated from the first rail 44. The user may carry out related maintenance of the slide rail assembly 10 according to this feature, or may further carry out related replacement or maintenance of the chassis when a chassis is mounted on the second rail 46.

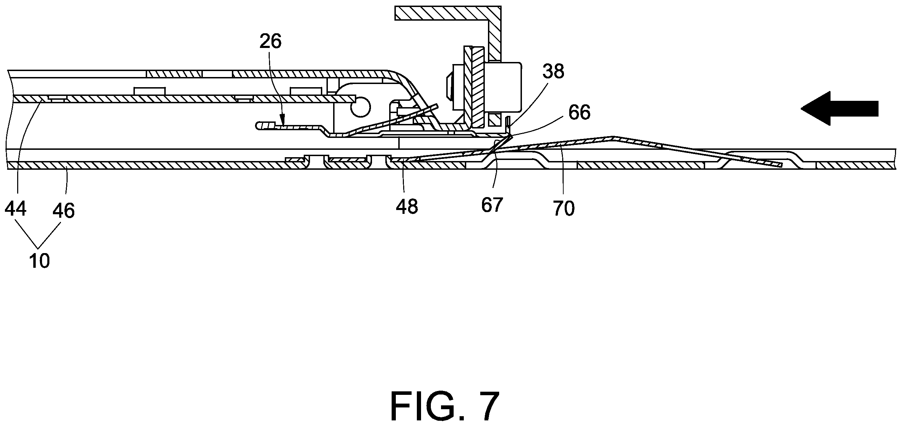

When the second rail 46 is put back to the first rail 44 (as in FIG. 6B), the user may directly push the second rail 46 in the withdrawing direction (i.e., opposite to the direction D) and the slant 67 of the engaging member 48 may thereby be pressed against by the second arm section 38 of the arm member 26 during the withdrawing process (as in FIG. 7) so that the inclining portion 70 of the engaging member 48 is correspondingly pressed (as in FIG. 6A), and the contact portion 66 of the engaging member 48 may subsequently pass the second arm section 38 of the arm member 26. As such, the second rail 46 may be withdrawn with respect to the first rail 44.

FIG. 8 shows a slide rail assembly according to another embodiment of the present invention. The difference between this embodiment and the above embodiments is that an arm member may be configured at a first rail of the slide rail assembly.

Specifically, the slide rail assembly comprises an arm member 200 that is movably connected to an end of a first rail 202 (such as a front end) and comprises a blocking portion 204. Preferably, the first rail 202 comprises a base 206 configured in the vicinity of the end of the first rail 202, wherein a connection member 208 pivotally connects the arm member 200 to the base 206 of the first rail 202. By such a structural configuration, after the slide rail assembly is correspondingly mounted to a post of a rack by means of a bracket assembly 210, a blocking portion 204 of the arm member 200 blocks a contact portion of an engaging member so that a second rail (not shown) is blocked at a predetermined position to ensure that the second rail is not to dislocated from the first rail 202. The related operations and principles are described in above and will not be repeated here for brevity.

While the invention has been described by way of example and in terms of the preferred embodiments, it is to be understood that the invention is not limited to the disclosed embodiments. Therefore, the scope of the appended claims should be accorded the broadest interpretation so as to encompass all such modifications and similar arrangements.

## Claims

1. A slide rail assembly (10) comprising a bracket assembly (12), wherein the bracket assembly (12) comprises a side plate (22) and an arm member (26), the arm member (26) connected to the side plate (22) and comprising a blocking portion (30), the slide rail assembly (10) comprising:
a first rail (44), connected to the side plate (22) of the bracket assembly (12);
a second rail (46), longitudinally and movably connected to the first rail (44);
and
an engaging member (48), connected to the second rail (46) and comprising a contact portion (66),
wherein when the second rail (46) is pulled and moved along a direction with respect to the first rail (44) to a predetermined position, the blocking portion (30) of the arm member (26) blocks the contact portion (66) of the engaging member (48) so that the second rail (46) is blocked at the predetermined position, **characterized in that** the slide rail assembly (10) is mountable to a rack by means of at least one said bracket assembly (12), wherein the rack comprises a post hole (20), wherein the arm member (26) of the bracket assembly (12) is movably connected to the side plate (22) of the bracket assembly (12), wherein the bracket assembly (12) further comprises an end plate (24) and a mounting member (28), wherein the end plate (24) bends from the side plate (22), and wherein the mounting member (28) is connected to the end plate (24) and mountable to the post hole (20) of the rack.

2. The slide rail assembly (10) as claimed in claim 1, wherein the side plate (22) of the bracket assembly (12) comprises a base (32), wherein the bracket assembly (12) further comprises a connection member (34), and wherein the connection member (34) pivotally connects the arm member (26) to the base (32) of the side plate (22).

3. The slide rail assembly (10) as claimed in claim 1, wherein the location of the blocking portion (30) of the bracket assembly (12) extends beyond the end plate (24) by a distance.

4. The slide rail assembly (10) as claimed in claim 1, wherein the first rail (44) comprises an end, and wherein the side plate (22) of the bracket assembly (12) is connected to the end of the first rail (44).

5. The slide rail assembly (10) as claimed in claim 1, wherein the engaging member (48) further comprises a base plate (68) connected to the second rail (46) and an inclining portion (70) bending from the base plate (68), wherein the contact portion (66) is located on the inclining portion (70), and wherein while the second rail (46) is located at the predetermined position, the contact portion (66) of the engaging member (48) is no longer blocked by the blocking portion (30) of the arm member (26) once the inclining portion (70) is pressed.

6. The slide rail assembly (10) as claimed in claim 5, wherein the contact portion (66) comprises a slant (67) corresponding to the arm member (26), and wherein when the second rail (46) is moved along an opposite direction with respect to the first rail (44) and drives the slant (67) to contact the arm member (26), the inclining portion (70) of the engaging member (48) is pressed so that the contact portion (66) of the engaging member (48) is allowed to pass the arm member (26).

7. The slide rail assembly (10) as claimed in claim 5, wherein the second rail (46) comprises a rail hole (60) and a hole edge (62) adjacent to the rail hole (60), wherein the engaging member (48) further comprises a supporting portion (72) connected to the inclining portion (70) and bent towards the second rail (46), and wherein the supporting portion (72) comprises a blocking wing (74) penetrating the rail hole (60) and blocked by the hole edge (62).

8. The slide rail assembly (10) as claimed in claim 1, wherein the arm member (26) further comprises an arm hole (40), wherein the blocking portion (30) is an edge adjacent to the arm hole (40), wherein the contact portion (66) of the engaging member (48) is a protrusion, and wherein when the second rail (46) is pulled and moved along the direction with respect to the first rail (44) to the predetermined position, the protrusion of the engaging member (48) is located at the arm hole (40) of the arm member (26) and is blocked by the edge of the arm member (26) to block the second rail (46) at the predetermined position.

9. The slide rail assembly (10) as claimed in claim 1, wherein the arm member (26) of the bracket assembly (12) further comprises a first arm section (36) and a second arm section (38) bending from the first arm section (36), and wherein the first arm section (36) comprises the blocking portion (30), and the second arm section (38) extends beyond the rack by a distance and faces the rack when the slide rail assembly (10) is mounted to the rack.

10. A slide rail assembly comprising a bracket assembly (210) and mountable to a rack by means of the bracket assembly (210), wherein the rack comprises a post hole (20), wherein the bracket assembly (210) comprises a side plate, an end plate bending from the side plate, and a mounting member connected to the end plate and mountable to the post hole (20) of the rack, **characterized in that** the slide rail assembly comprising:
a first rail (202), connected to the side plate of the bracket assembly (210) and comprising an end;
a second rail, longitudinally and movably connected to the first rail (202);
an arm member (200), movably connected to the end of the first rail (202) and comprising a blocking portion (204); and
an engaging member, connected to the second rail and comprising a contact portion,
wherein when the second rail is pulled and moved along a direction with respect to the first rail (202) to a predetermined position, the blocking portion (204) of the arm member (200) blocks the contact portion of the engaging member so that the second rail is blocked at the predetermined position.

11. The slide rail assembly as claimed in claim 10, wherein the first rail (202) comprises a base (206), and wherein a connection member (208) pivotally connects the arm member (200) to the base (206) of the first rail (202).

## Patentansprüche

1. Eine Laufschiene (10), umfassend eine Halterung (12), wobei diese Halterung (12) ein Seitenplättchen (22) und einen Querträger (26) umfaßt; der Querträger (26) am Seitenplättchen (22) befestigt ist und einen Sperrteil (30) umfaßt; die Laufschiene (10) die folgenden Komponenten umfassend:
eine erste Schiene (44), die am Seitenplättchen (22) der Halterung (12) befestigt ist;
eine zweite Schiene (46), die der Länge nach und beweglich an der ersten Schiene (44) befestigt ist; und
ein Eingriffglied (48), das an der zweiten Schiene (46) befestigt ist und einen Kontaktteil (66) umfaßt;
wobei der Sperrteil (30) des Querträgers (26) den Kontaktteil (66) des Eingriffglieds (48) blockiert, so dass die zweite Schiene (46) in einer bestimmten Position blockiert wird, wenn die zweite Schiene (46) gezogen und in eine Richtung bezüglich der ersten Schiene (44) entlang bewegt wird, **dadurch gekennzeichnet, dass** die Laufschiene (10) mit mindestens einer Halterung (12) an ein Regal montiert werden kann; wobei das Regal ein Pfostenloch (20) aufweist; der Querträger (26) der Halterung (12) beweglich am Seitenplättchen (22) der Halterung (112) befestigt ist; die Halterung (12) weiter ein Endplättchen (24) und ein Montageglied (28) umfaßt; das Endplättchen (24) vom Seitenplättchen (22) gebogen wird und wobei das Montageglied (28) am Endplättchen (24) befestigt ist und an das Pfostenloch (20) des Regals montiert werden kann.

2. Die Laufschiene (10) nach Anspruch 1, wobei das Seitenplättchen (22) der Halterung (12) eine Basis (32) umfaßt; die Halterung (12) weiter ein Verbindungsglied (34) umfaßt und der Querträger (26) mit dem Verbindungsglied (34) drehgelenkig an der Basis (32) des Seitenplättchens (22) befestigt ist.

3. Die Laufschiene (10) nach Anspruch 1, wobei der Standort des Sperrteils (30) der Halterung (12) um einen Abstand über das Endplättchen (24) hinausreicht.

4. Die Laufschiene (10) nach Anspruch 1, wobei die erste Schiene (44) ein Ende aufweist und das Seitenplättchen (22) der Halterung (12) an einem Ende der ersten Schiene (44) befestigt wird.

5. Die Laufschiene (10) nach Anspruch 1, wobei das Eingriffglied (48) weiter eine Grundplatte (68) umfaßt, die an der zweiten Schiene (46) befestigt ist, während ein abgeschrägtes Element (70) von der Grundplatte (68) gebogen ist; der Kontaktteil (66) am abgeschrägten Element (70) vorgesehen ist; die zweite Schiene (46) in der vorbestimmten Position angeordnet ist, während der Kontaktteil (66) des Eingriffglieds (48) beim Drücken auf das abgeschrägte Element (70) nicht mehr mit dem Sperrteil (30) des Querträgers (26) blockiert wird.

6. Die Laufschiene (10) nach Anspruch 5, wobei der Kontaktteil (66) eine Schräglage (67) in Übereinstimmung mit dem Querträger (26) aufweist; beim Bewegen der zweiten Schiene (46) in eine entgegengesetzte Richtung hinsichtlich der ersten Schiene (44) und dabei die Schräglage (67) verschoben wird, damit diese mit dem Querträger (26) in Berührung kommt; das abgeschrägte Element (70) des Eingriffglieds (48) angedrückt wird, um das Kontaktteil (66) des Eingriffglieds (48) am Querträger (26) vorbeizuführen.

7. Die Laufschiene (10) nach Anspruch 5, wobei die zweite Schiene (46) ein Schienenloch (60) und einen Lochrand (62) neben diesem Schienenloch (60) aufweist; das Eingriffglied (48) weiter einen Stützteil (72) umfaßt, der am abgeschrägten Element (70) befestigt und zur zweiten Schiene (46) gebogen ist; das Eingriffglied (48) weiter einen Stützteil (72) umfaßt, der am abgeschrägten Element (70) befestigt und auf die zweite Schiene (46) zu gebogen ist; der Stützteil (72) einen Sperrflügel (74) umfaßt, der durch das Schienenloch (60) ragt und mit dem Lochrand (62) blockiert wird.

8. Die Laufschiene (10) nach Anspruch 1, wobei der Querträger (26) weiter ein Armloch (40) aufweist; wobei der Sperrteil (30) als eine Kante neben dem Armloch (40) gebildet ist; wobei der Kontaktteil (66) des Eingriffgliedes (48) als einen Vorsprung gebildet ist; die zweite Schiene (46) gezogen und in die Richtung bezüglich der ersten Schiene (44) in eine vorbestimmte Position bewegt wird; der Vorsprung des Eingriffgliedes (48) am Armloch (40) des Querträgers (26) vorgesehen ist und mit der Kante des Querträgers (26) blockiert wird, um die zweite Schiene (46) in der vorbestimmten Position zu blockieren.

9. Die Laufschiene (10) nach Anspruch 1, wobei der Querträger (26) der Halterung (12) weiter einen ersten Armabschnitt (36) und einen zweiten Armabschnitt (38) umfaßt und dabei letzterer vom ersten Armabschnitt (36) gebogen ist; der erste Armabschnitt (36) den Sperrteil (30) umfaßt und der zweite Armabschnitt (38) um einen Abstand über das Regal hinausragt und gegenüber dem Regal angeordnet ist, wenn die Laufschiene nach Anspruch (10) an das Regal montiert wird.

10. Eine Laufschiene mit einer Halterung (210) und die mit dieser Halterung (210) an ein Regal montiert werden kann, wobei das Regal ein Pfostenloch (20) aufweist und die Halterung (210) ein Seitenplättchen, ein Endplättchen, das vom Seitenplättchen gebogen ist, und ein Montageglied, das am Endplättchen befestigt ist und an das Pfostenloch (20) des Regals montiert werden kann, umfaßt, **dadurch gekennzeichnet, dass** die Laufschiene die folgenden Komponenten umfassend:
Eine erste Schiene (202), die am Seitenplättchen der Halterung (210) befestigt ist und einen Endteil aufweist;
eine zweite Schiene, die der Länge nach und beweglich an der ersten Schiene (20) befestigt ist;
einen Querträger (200), der beweglich am Ende der ersten Schiene (202) befestigt ist und einen Sperrteil (204) aufweist; und
ein Eingriffglied, das an der zweiten Schiene befestigt ist und einen Kontaktteil umfaßt,
wobei beim Ziehen der zweiten Schiene und wenn diese in eine Richtung gegenüber der ersten Schiene (202) in eine vorbestimmte Position bewegt wird der Sperrteil (204) des Querträgers (200) den Kontaktteil des Eingriffglieds blockiert, um die zweite Schiene in der vorbestimmten Position zu blockieren.

11. Die Laufschiene nach Anspruch 10, wobei die erste Schiene (202) eine Basis (206) umfaßt und der Querträger (200) mit dem Verbindungsglied (208) drehgelenkig an die Basis (206) der ersten Schiene (202) befestigt wird.

## Revendications

1. Ensemble de glissières (10) comprenant un ensemble de support (12), l'ensemble de support (12) comprend une plaque latérale (22) et un élément formant bras (26), l'élément formant bras (26) raccordé à la plaque latérale (22) et comprenant une partie de blocage (30), l'ensemble de glissières (10) **caractérisée par le fait qu'**elle comprend :
un premier rail (44), raccordé à la plaque latérale (22) de l'ensemble de support (12) ;
un second rail (46), raccordé de manière longitudinale et mobile au premier rail (44) ; et
un élément d'engagement (48), raccordé au second rail (46) et comprenant une partie de contact (66),
lorsque le second rail (46) est tiré et déplacé le long d'une direction par rapport au premier rail (44) vers une position prédéterminée, la partie de blocage (30) de l'élément formant bras (26) bloque la partie de contact (66) de l'élément d'engagement (48) de sorte que le second rail (46) est bloqué sur la position prédéterminée, **caractérisé en ce que** l'ensemble de glissières (10) est montable sur un châssis grâce à au moins un ensemble de support (12), le châssis comprend un trou de montant (20), l'élément formant bras (26) de l'ensemble de support (12) est raccordé de manière mobile à la plaque latérale (22) de l'ensemble de support (12), l'ensemble de support (12) comprend en outre une plaque d'extrémité (24) et un élément de montage (28), la plaque d'extrémité (24) coudée à partir de la plaque latérale (22), et l'élément de montage (28) est raccordé à la plaque d'extrémité (24) et montable sur le trou de montant (20) du châssis.

2. Ensemble de glissières (10) selon la revendication 1, **caractérisée par** le fait quela plaque latérale (22) de l'ensemble de support (12) comprend a base (32), l'ensemble de support (12) comprend en outre un élément de liaison (34), et l'élément de liaison (34) raccorde de manière pivotante l'élément formant bras (26) à la base (32) de la plaque latérale (22).

3. Ensemble de glissières (10) selon la revendication 1, **caractérisée par** le fait quel'emplacement de la partie de blocage (30) de l'ensemble de support (12) s'étend au-delà de la plaque d'extrémité (24) par une distance.

4. Ensemble de glissières (10) selon la revendication 1, **caractérisée par** le fait quele premier rail (44) comprend une extrémité, et la plaque latérale (22) de l'ensemble de support (12) est raccordée à l'extrémité du premier rail (44).

5. Ensemble de glissières (10) selon la revendication 1, **caractérisée par** le fait quel'élément d'engagement (48) comprend en outre une plaque de base (68) raccordé au second rail (46) et une partie inclinée (70) coudée à partir de la plaque de base (68), la partie de contact (66) est située sur la partie inclinée (70), et alors que le second rail (46) est situé à la position prédéterminée, la partie de contact (66) de l'élément d'engagement (48) n'est plus bloquée par la partie de blocage (30) de l'élément formant bras (26) une fois la partie inclinée (70) pressée.

6. Ensemble de glissières (10) selon la revendication 5, **caractérisée par** le fait quela partie de contact (66) comprend un plan incliné (67) correspondant à l'élément formant bras (26), et lorsque le second rail (46) est déplacé le long d'une direction opposée par rapport au premier rail (44) et entraîne le plan incliné (67) à entrer en contact avec l'élément formant bras (26), la partie inclinée (70) de l'élément d'engagement (48) est pressée de sorte que la partie de contact (66) de l'élément d'engagement (48) peut passer l'élément formant bras (26).

7. Ensemble de glissières (10) selon la revendication 5, **caractérisée par** le fait quele second rail (46) comprend un trou de rail (60) et un rebord de trou (62) adjacent au trou de rail (60), l'élément d'engagement (48) comprend en outre une partie de support (72) raccordée à la partie inclinée (70) et courbée vers le second rail (46), et la partie de support (72) comprend une ailette de blocage (74) pénétrant le trou de rail (60) et bloquée par le rebord de trou (62).

8. Ensemble de glissières (10) selon la revendication 1, **caractérisée par** le fait quel'élément formant bras (26) comprend en outre un trou de bras (40), la partie de blocage (30) est un rebord adjacent au trou de bras (40), a partie de contact (66) de l'élément d'engagement (48) est une saillie, et lorsque le second rail (46) est tiré et déplacé le long de la direction par rapport au premier rail (44) vers la position prédéterminée, la saillie de l'élément d'engagement (48) est située au trou de bras (40) de l'élément formant bras (26) et est bloquée par le rebord de l'élément formant bras (26) pour bloquer le second rail (46) à la position prédéterminée.

9. Ensemble de glissières (10) selon la revendication 1, **caractérisée par** le fait quel'élément formant bras (26) de l'ensemble de support (12) comprend en outre une première section de bras (36) et une seconde section de bras (38) coudée à partir de la première section de bras (36), et la première section de bras (36) comprend la partie de blocage (30), et la seconde section de bras (38) s'étend au-delà du châssis par une distance et fait face au châssis lorsque l'ensemble de glissières (10) est monté sur le châssis.

10. Ensemble de glissières comprenant un ensemble de support (210) et montable sur un châssis grâce à l'ensemble de support (210), le châssis comprend un trou de montant (20), l'ensemble de support (210) comprend une plaque latérale, une plaque d'extrémité coudée à partir de la plaque latérale, et un élément de montage raccordé à la plaque d'extrémité et montable sur le trou de montant (20) du châssis, **caractérisé en ce que** l'ensemble de glissières **caractérisée par le fait qu'**elle comprend :
un premier rail (202), raccordé à la plaque latérale de l'ensemble de support (210) et comprenant une extrémité ;
un second rail, raccordé de manière longitudinale et mobile au premier rail (202) ;
un élément formant bras (200), raccordé de manière mobile à l'extrémité du premier rail (202) et comprenant une partie de blocage (204) ; et
un élément d'engagement, raccordé au second rail et comprenant une partie de contact,
lorsque le second rail est tiré et déplacé le long d'une direction par rapport au premier rail (202) vers une position prédéterminée, la partie de blocage (204) de l'élément formant bras (200) bloque la partie de contact de l'élément d'engagement de sorte que le second rail est bloqué sur la position prédéterminée.

11. Ensemble de glissières selon la revendication 10, **caractérisée par** le fait quele premier rail (202) comprend une base (206), et un élément de liaison (208) raccorde de manière pivotante l'élément formant bras (200) à la base (206) du premier rail (202).
